# EUROPEAN PATENT SPECIFICATION

(11) **EP 4 292 028 B1**
(45) Date of publication and mention of the grant of the patent: **01.04.2026**
(21) Application number: 22753330.4
(22) Date of filing: 10.02.2022
(51) Int. Cl.: G06N 20/00, G06F 30/00, G06F 30/17, G06F 30/27, G06F 30/15, G06N 3/045, G06N 3/088, G06N 20/10

(54) **SYSTEMS AND METHODS FOR IMPROVING A DESIGN OF ARTICLE USING EXPERT EMULATION**
SYSTEME UND VERFAHREN ZUR VERBESSERUNG EINES ENTWURFS EINES ARTIKELS UNTER VERWENDUNG VON EXPERTENEMULATION
SYSTÈMES ET PROCÉDÉS D'AMÉLIORATION D'UNE CONCEPTION D'ARTICLE À L'AIDE D'UNE ÉMULATION D'EXPERT

(30) Priority: 12.02.2021 US 202163149138 P
(43) Date of publication of application: 20.12.2023
(73) Proprietor: Altair Engineering Inc., Troy, Michigan 48083 (US)
(72) Inventor: OLLAR, Jonathan, London Middlesex N16 0JU (GB)
(74) Representative: HKW Intellectual Property PartG mbB
(86) International application number: PCT/US2022/015948
(87) International publication number: WO 2022/173929

(56) References cited:
- WO-A1-2020/033910
- US-A1- 2017 216 981
- US-A1- 2019 156 298
- KAPTEYN MICHAEL G. ET AL: "Toward predictive digital twins via component-based reduced-order models and interpretable machine learning", 6 January 2020 (2020-01-06), Reston, Virginia, XP055833627, Retrieved from the Internet <URL:https://kiwi.oden.utexas.edu/papers/Predictive-digital-twin-interpretable-machine-learning-Kapteyn-Knezevic-Willcox.pdf> DOI: 10.2514/6.2020-0418
- HWAN GOH ET AL: "Solving Forward and Inverse Problems Using Autoencoders", ARXIV.ORG, CORNELL UNIVERSITY LIBRARY, 201 OLIN LIBRARY CORNELL UNIVERSITY ITHACA, NY 14853, 5 December 2019 (2019-12-05), XP081548130
- ANONYMOUS: "Principal component regression", WIKIPEDIA, 24 December 2020 (2020-12-24), XP093255134, Retrieved from the Internet <URL:https://en.wikipedia.org/w/index.php?title=Principal_component_regression&oldid=996145984>

## Description

### TECHNICAL FIELD

This description relates to computer systems for design exploration and optimization.

### BACKGROUND

Computers can be used to design articles for use in various applications. As an example, a computer can be used to design structural components for use in a vehicle, such as a support beam.

Further, computers can be used to optimize the structural design of the article. However, one of the challenges of structural optimization is defining the optimization problem. For example, during an optimizing process, design requirements are often translated into a measurable quantity with a corresponding target value. However, there are frequently requirements that are difficult to express in terms of measurable numbers, for example, the styling of a vehicle or the suitability of an article for a particular task. These are called "subjective design requirements." Further, enforcing a preferred property (e.g., the shape of a vehicle or other article) may be difficult and can lead to over constraining the problem resulting in a solution that is no better than the starting point.

US 2019/156298 A1 categorizes systems into clusters using an unsupervised machine learning method to analyze repair data parameters of a historical dataset.

M. G. Kapteyn et al, AIAA SCITECH 2020 FORUM describes a library of physics-based reduced-order models.

WO 2020/033910 Al describes techniques for generating designs that reflect stylistic preferences.

### SUMMARY

The implementations described herein can provide a variety of benefits. For instance, the expert emulation platform described herein can enable input of subjective design constraints when determining design parameters of an article. As an example, the expert emulation article can use classification algorithms to classify an article design as "good," "bad," etc. according to classification labels previously specified by an expert user.

The invention is defined in the appended claims. In an aspect, a method includes: receiving, by one or more processors, a plurality of first sets of design parameters for a structural design of an article; determining, by the one or more processors, a plurality of first sets of features of the structural design of the article based on the first sets of design parameters; determining, by the one or processors, a plurality of second sets of features of the structural design of the article by reducing a dimensionality of each of the first sets of features; training, by the one or more processors, a predictive model based on the first sets of design parameters and the second sets of features, where the predictive model is trained to predict a third set of features of the structural design of the article as a function of an input set of design parameters for the structural design of the article; clustering, by the one or more processors, the second set of features into a plurality of clusters; training, by the one or more processors, a classifier model based on the clusters, where the classifier model is trained to predict a quality metric of the structural design of the article as a function of an input set of features of, the quality metric corresponding to a subjective evaluation of the structural design; receiving, by the one or more processors, a second set of design variables for the structural design of the article; determining, by the one or more processors, the third set of features of the structural design of the article based on the second set of design variables and the predictive model; and determining, by the one or processors, the quality metric of the structural design of the article based on the third set of features and the classifier model.

Implementations of this aspect can include one or more of the following features.

In some implementations, the article is a structural component of a vehicle.

In some implementations, at least one of the first sets of design parameters includes an indication of a thickness of a portion of the structural component.

In some implementations, at least one of the first sets of design parameters includes an indication of a location of a portion of the structural component.

In some implementations, at least one of the first sets of features includes an indication of one or more deformations of the structural component in response to an applied force.

In some implementations, at least one of the second sets of features includes an indication of one or more deformations of the structural component in response to an applied force.

In some implementations, the dimensionality of each of the first sets of features is reduced by at least one of principal component analysis or an auto-encoder.

In some implementations, the predictive model is trained using at least one of a least square regression analysis, Gaussian process regression analysis, or a neural network.

In some implementations, the classifier is trained using at least one of a logistic regression analysis, a random forest analysis, or a neural network.

In some implementations, wherein the classifier model is trained based on input by a user.

In some implementations, the input includes, for at least some of the clusters, an indication of a respective quality metric assigned to that cluster by a user.

In some implementations, the method can further include determining, by the one or more processors, a fourth set of features of the structural design of the article by increasing a dimensionality of the third set of features.

In some implementations, the dimensionality of the third set of features is increased by at least one of principal component analysis or an auto-encoder.

Other implementations are directed to systems, devices and non-transitory, computer-readable mediums (e.g., for performing one or more of the techniques described herein). As an example, in an aspect, a system for performing one or more of the techniques described herein can include one or more processors, and one or more non-transitory computer-readable media including one or more sequences of instructions which, when executed by the one or more processors, causes the performance of one or more of the techniques described herein. As another example, in another aspect, one or more non-transitory computer-readable media can include one or more sequences of instructions which, when executed by one or more processors, causes the performance of one or more of the techniques described herein.

The details of one or more embodiments are set forth in the accompanying drawings and the description below. Other features and advantages will be apparent from the description and drawings, and from the claims.

### BRIEF DESCRIPTION OF THE DRAWINGS

FIG. 1 is a diagram of an example system for expert emulation.
FIG. 2 is a diagram of an example expert emulation platform.
FIG. 3 is a diagram of examples of preferred shapes.
FIG. 4 is a diagram of an example method of metamodel based optimization
FIG. 5 is a diagram of an example process for expert emulation.
FIG. 6 is an example diagram of the output of a clustering algorithm.
FIG. 7 is a flow chart diagram of an example process for expert emulation.
FIG. 8 is a diagram of an example computer system.

### DETAILED DESCRIPTION

Incorporating subjective design requirements into models is a challenging problem that is not easy to express in a categorical fashion. For example, the styling of a vehicle or the suitability of an article for a particular task cannot necessarily be measured. These are called "subjective design requirements." The judgement will depend on the expert and hence a need for "expert emulation" exists. In some cases enforcing a preferred property (e.g., the shape of a vehicle or other article) is difficult and can lead to over constraining the problem resulting in a solution that is no better than the starting point.

Described herein are systems and methods for emulating expert preference for subjective design items without causing over-constraint of the optimization problem. The systems and methods described herein allow a user to, in a computationally efficient manner, group, predict, and classify finite element analysis result data from design explorations such that structural optimization can be carried out while targeting a specific class of results (e.g., a specific deformation mode) by stating a preference between automatically generated groups. The systems and methods allow expert preference to be taken into account in structural optimization while also reducing multiple iterations due to undesirable or unfeasible optimum designs.

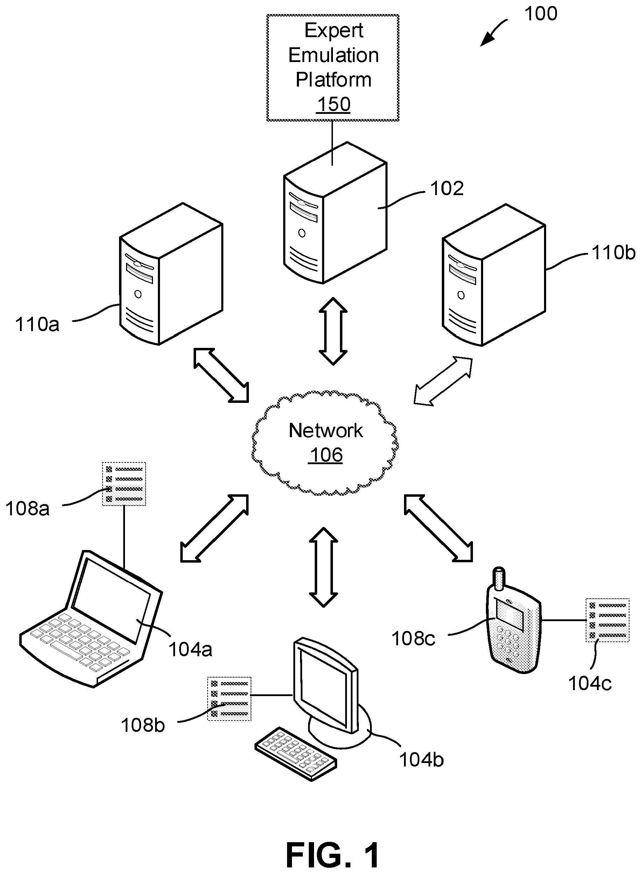

An example system 100 for expert emulation is shown in FIG. 1. The system 100 includes an expert emulation platform 150 maintained on a server computer system 102 that includes one or more server computers.

The server computer system 102 is illustrated as a respective single component. However, in practice, it can be implemented on one or more computing devices (e.g., each computing device including at least one processor such as a microprocessor or microcontroller). A server computer system 102 can be, for instance, a single computing device that is connected to the network 106, and the expert emulation platform 150 can be maintained and operated on the single computing device. In some implementations, the expert emulation platform may be executed as one aspect of a design optimization package. In some implementations, the server computer system 102 can include multiple computing devices that are connected to the network 106, and the expert emulation platform 150 can be maintained and operated on some or all of the computing devices. For instance, the server computer system 102 can include several computing devices, and the expert emulation platform 150 can be distributive on one or more of these computing devices. In some implementations, the server computer system 102 need not be located locally to the rest of the system 100, and portions of a server computer system 102 can be located in one or more remote physical locations.

The server computer system 102 is communicatively connected to client computer systems 104a-c using the network 106. Each client computer system 104a-c includes a respective user interface 108a-c. Users interact with the user interfaces 108a-c to view data (e.g., data on the server computer system 102 and the platform 150, and/or data on other the client computer systems 104a-c). Users also interact with the user interfaces 108a-c to transmit data to other devices (e.g., to the server computer system 102 and the platform 150, and/or to the other client computer systems 104a-c). Users interact with the user interfaces 108a-c to issue commands (e.g., to the server computer system 102 and the platform 150, and/or to the other client computer systems 104a-c). Commands can be, for example, any user instruction to the server computer system 102 and/or to the other client computer systems 104a-c. In some implementations, a user can install a software application onto a client computer system 104a-c in order to facilitate performance of these tasks.

A client computer system 104a-c can be any electronic device that is used by a user to view, process, transmit and receive data. Examples of the client computer systems 104a-c include computers (such as desktop computers, notebook computers, server systems, etc.), mobile computing devices (such as cellular phones, smartphones, tablets, personal data assistants, notebook computers with networking capability), and other computing devices capable of transmitting and receiving data from the network 106. The client computer systems 104a-c can include devices that operate using one or more operating system (e.g., Microsoft Windows, Apple OS X, Linux, Unix, Android, Apple iOS, etc.) and/or architectures (e.g., x86, PowerPC, ARM, etc.) In some implementations, one or more of the client computer systems 104a-c need not be located locally with respect to the rest of the system 100, and one or more of the client computer systems 104a-c can be located in one or more remote physical locations.

The server computer system 102 is also communicatively connected to expert emulation computer systems 110a and 110b using the network 106. The expert emulation computer systems 110a and 110b store electronic content items (e.g., one or more data files, images, audio files, video files, computerized models, text files, and/or other electronic content). Each expert emulation computer system 110a and 110b is illustrated as a respective single component. However, in practice, an expert emulation computer system 110a or 110b can be implemented on one or more computing devices (e.g., each computing device including at least one processor such as a microprocessor or microcontroller). An expert emulation computer system 110a or 110b can be, for instance, a single computing device that is connected to the network 106. In some implementations, an expert emulation computer system 110a or 110b can include multiple computing devices that are connected to the network 106. In some implementations, the expert emulation computer system 110a and 110b need not be located locally to the rest of the system 100, and portions of the expert emulation computer system 110a and 110b can be located in one or more remote physical locations.

The network 106 can be any communications network through which data can be transferred and shared. For example, the network 106 can be a local area network (LAN) or a wide-area network (WAN), such as the Internet. The network 106 can be implemented using various networking interfaces, for instance wireless networking interfaces (such as Wi-Fi, Bluetooth, or infrared) or wired networking interfaces (such as Ethernet or serial connection). The network 106 also can include combinations of more than one network, and can be implemented using one or more networking interfaces.

In some embodiments the expert emulation platform may be executed on a stand-alone workstation. The workstation may or may not be connected to a network.

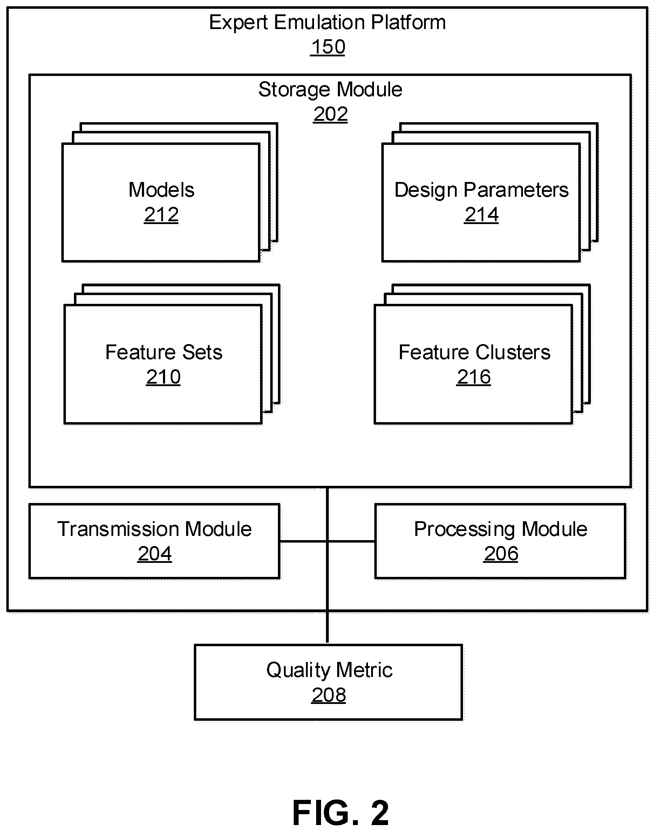

FIG. 2 shows various aspects of the expert emulation platform 150. The expert emulation platform 150 includes several modules that perform particular functions related to the operation of the system 100. For example, the expert emulation platform 150 can include a storage module 202, a transmission module 204, and a processing module 206. The output of the expert emulation platform 150 can be a quality metric 208, which predicts whether input design parameters are likely to result in a good outcome.

The storage module 202 can store one or more data files, images, audio files, video files, computerized models (e.g., machine learning models, prediction models, classification models, clustering models, CAD models, CAE models, etc.), text files, and/or other electronic content. In some cases, at least some of the electronic content items stored by the storage module 202 are obtained from the expert emulation computer systems 110a and/or 110b. Further, the storage module 202 can store information describing the electronic content items.

As another example, if the electronic content item is a computerized model, or specification of a component or system, the storage module 202 can store a description of the component or system, an indication of a category or classification of the component or system, and/or other information regarding the component or system. The storage module 202 can store one or more feature sets 210 for use by the expert emulation platform 150. One or more of the feature sets can include, for example, an indication of one or more deformations of the structural component in response to an applied force.

In some embodiments one or more of the feature sets can be provided to a dimensionality reduction model, to reduce the size of the feature set, and increase the scalability for large problems. The reduced feature set can be stored as a further feature set (e.g., second feature set) of the one or more features sets 210 at the storage module 202. The feature sets can be used in conjunction with one or more models 212, for example a dimensionality reduction model. The one or more feature sets (e.g., the reduced feature set) can be used with one or more design parameters 214 (e.g., length, thickness, width, material) of a structural component and one or more further models 212 (e.g., classification model, clustering model, prediction model) to produce one or more further feature sets 210 or feature clusters 216. Feature clusters 216 can further be used as a model input (e.g., to a prediction model) to obtain the quality metric 218.

The transmission module 204 allows for the transmission of data to and from the expert emulation platform 150. For example, the transmission module 204 can be communicatively connected to the network 106, such that it can transmit data to the client computer systems 104a-c, and receive data from the client computer systems 104a-c via the network 106. As an example, information inputted by users on the client computer systems 104a-c can be transmitted to the expert emulation platform 150 through the transmission module 204. This information can then be processed (e.g., using the processing module 206) and/or stored (e.g., using the storage module 202). As another example, information from the expert emulation platform 150 (e.g., information stored on the storage module 202) can be transmitted to the client computer systems 104a-c through transmission module 204.

The processing module 206 processes data stored or otherwise accessible to the expert emulation platform 150. For instance, the processing module 206 can execute automated or user-initiated processes that manipulate data pertaining to one or more users or electronic content items. As an example, the processing module 206 can generate train and deploy models 212 stored at the storage module 202. Further, the processing module 206 can process data that is received from the transmission module 204 or stored at the storage module 202, e.g., feature sets 210, design parameters 214, and feature clusters 216. Likewise, processed data from the processing module 206 can be stored on the storage module 202 and/or sent to the transmission module 204 for transmission to other devices. Example processes that can be performed by the processing module 206 are described in greater detail below.

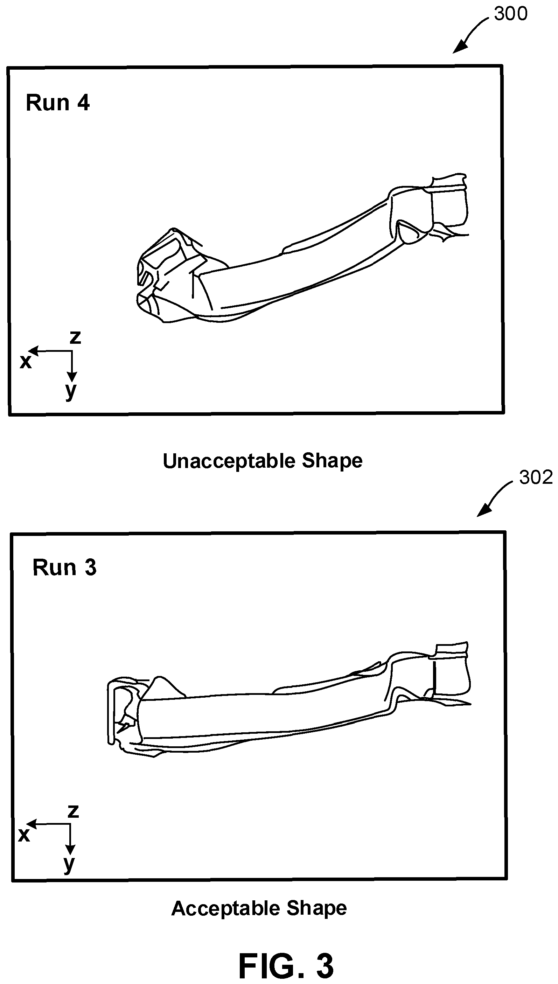

As described above, one or more implementations of the expert emulation platform 150 enables a user to determine a quality metric for various solutions to a structural optimization problem. In some implementations, the quality metric can be used to improve a design of an article, such as a structural component of a vehicle (e.g., a support beam), a structural component of a building, a consumer product, or any other article. An example of this functionality is illustrated in FIGS. 3-5.

FIG. 3 is a diagram of examples of preferred shapes for a structural component of a vehicle (e.g., a support beam). Structural optimization is the process of finding the design parameters that minimize or maximize an objective function while satisfying design requirements. For example, structural optimization can be performed to find the thickness and/or width of a bridge such that the bridge weight is minimized while requirements on deformation are met. Defining the structural optimization problem can be a challenging task. For instance, every design requirement may need to be translated to a measurable quantity with a corresponding target value (e.g., maximum displacement <5mm). Some requirements can be difficult to express in terms of measurable numbers, for example the styling of a vehicle or the suitability of an article for a particular task. For example, it may depend on the judgement of the designer whether the styling requirements are acceptable or unacceptable, or whether an article is sufficiently suitable.

One example of designer judgement is whether a level of deformation of a shape would be acceptable. For example, designer judgement may be used to determine what level of deformation would be acceptable when a specified level of force is applied to a vehicle component. FIG. 3 shows an example shape 300 that would be considered unacceptable, and an example shape 302 that would be acceptable according to designer judgment. The example shows two different designs being subjected to the same loading condition and, as a consequence, deforming differently. The shape 302 has an acceptable deformation, whereas the shape 300 does not. Enforcing the preferred shape is difficult and may result in over constraining the problem. Over constraining the problem can lead to the solution showing no improvement over the starting point.

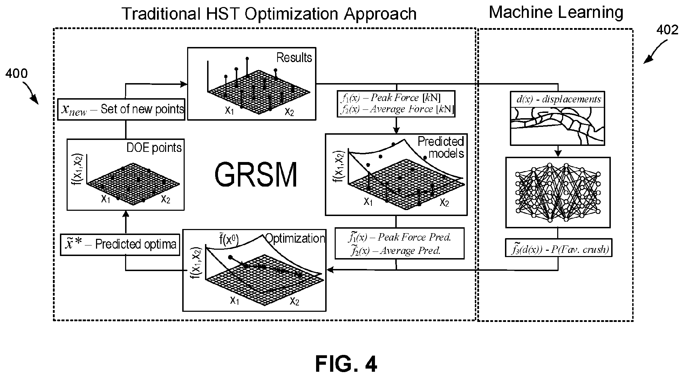

FIG. 4 is a diagram of a method of metamodel based optimization.

In general, in a metamodel, existing data can be used to create mathematical models that can predict the responses as function of the design parameters. These models can be used lieu of, for instance, running time consuming simulations. An optimization method is used to find the combination of design parameters that best satisfies the optimization problem. Subjective design requirements are then manually selected by the user.

In an example implementation, existing data can be used to create mathematical models 400 that can predict responses as a function of the design parameters. Other examples of responses the mathematical models 400 can predict are energy absorption, maximum force, maximum deformation, and maximum stress. The responses can be predicted as a function of design variables such as height, width, radii, thickness, etc. The mathematical models can be used to predict one or more response parameters. A predictive model can, for example, use one or more classifiers to predict a response e.g., by predicting a category as a function of the input parameters. In another example, a regression model can predict a value as a function of input parameters. Predictive models can be parametric (e.g., a family of probability distributions where all the parameters are in finite-dimensional parameter space), non-parametric (e.g., where all the parameters are in infinite-dimensional parameter space), or a combination thereof.

An optimization method 402 can be used to find the combination of design parameters that best satisfies the optimization problem. Depending on the parameters the optimization can be a discrete optimization or a continuous optimization. Optimization methods can include maximizing or minimizing a real function by systematically choosing input values from within an allowed set and computing the value of the function.

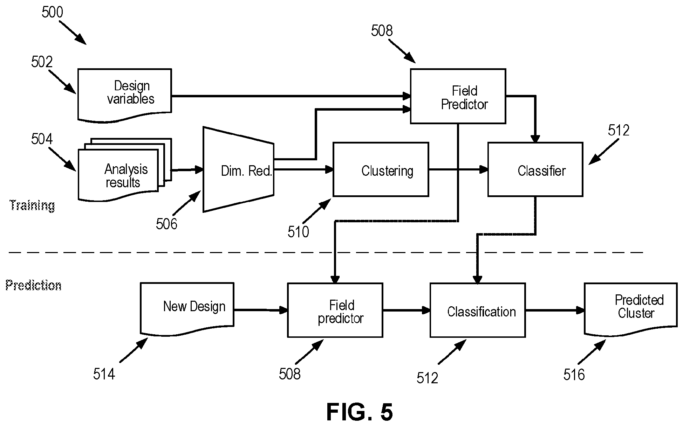

Subjective design requirements (e.g., preferred shapes of an article) can be determined based on input of a human user, such as an expert designer. An additional predictive model 404 using machine learning techniques can be used to predict the probability that a design will be preferred. This can be used as an additional constraint of the optimization. The model to predict expert preference is described in more detail with reference to FIG. 5.

FIG. 5 is a diagram of an example process 500 for expert emulation. A first set of design variables 502 (e.g., height, width, width, radii, and/or thickness, from a displacement analysis) is received, e.g., by the expert emulation platform 150. At least one of the first sets of design parameters can include at an indication of a thickness of at least a portion of a structural component or an indication of a location of a portion of the structural component.

Several first sets of features 504 (e.g., displacement results from a finite element analysis can be determined based on the first sets of design parameters. The first sets of features can include an indication of one or more deformations of the structural component in response to an applied force. The plurality of first sets of features 504 can be provided to a dimensionality reduction algorithm 506 to determine several second sets of features of the structural design of the article by reducing a dimensionality of each of the first sets of features. The plurality of second sets of features can include an indication of one or more deformations of the structural component in response to an applied force with a reduced set of dimensionality compared to the plurality of first set of features.

In an example the dimensionality reduction algorithm is one of principal component analysis or an auto-encoder.

For example, Principal Component Analysis (PCA) is a method for reducing the dimensionality of data. Data with m-columns (features) is projected into a subspace with m or fewer columns. The first set of features can be represented by an n x m matrix. A mean value is computed for each column in the matric and the values in each column are centered by subtracting the mean column value. A covariance matrix can be calculated by computing the covariance the matrix with covariance scores for every column with every other column, including itself. An eigen decomposition of the covariance matrix can be computed. This results in a list of eigenvalues and a list of eigenvectors. If all eigenvalues have a similar value, then the existing representation may already be reasonably compressed or dense and that the projection may offer little. In a first example, if there are eigenvalues close to zero, they represent components that may be discarded, therefore all eigenvalues with a value below a certain threshold are removed. In another example, to reduce the set of features the k eigenvalues with the highest value can be selected. Since there is a high correlation between neighboring nodes in the finite element analysis, the size of the result set may be reduced by several orders of magnitude.

In another example, an autoencoder can be used to reduce the dimensionality of the first set feature. An autoencoder is a neural network that learns to copy its input to its output. It has an internal (hidden) layer that describes a code used to represent the input, and it is constituted by two main parts: an encoder that maps the input into the code, and a decoder that maps the code to a reconstruction of the input. Autoencoders are restricted in ways that force them to reconstruct the input approximately, preserving only the most relevant aspects of the data in the copy. Other example techniques to reduce the dimensionality of the data can be matrix- factorization, Uniform manifold approximation and projection (UMAP) or other feature selection or transformation algorithms.

A predictive model 508 can be trained based on the first sets of design parameters and the second sets of features. The predictive model 508 is trained to predict a third set of features of the structural design of the article as a function of an input set of design parameters for the structural design of the article. The third set of features can be mapped back to the full space at any time to predict the analysis result. That is, a fourth set of features of the structural design of the article can be generated by increasing a dimensionality of the third set of features using further principle component analysis, autoencoder or other feature selection algorithm.

The predictive model 508 can be trained using any appropriate regression algorithm, for example, at least one of a least square regression analysis, Gaussian process regression analysis, or a neural network.

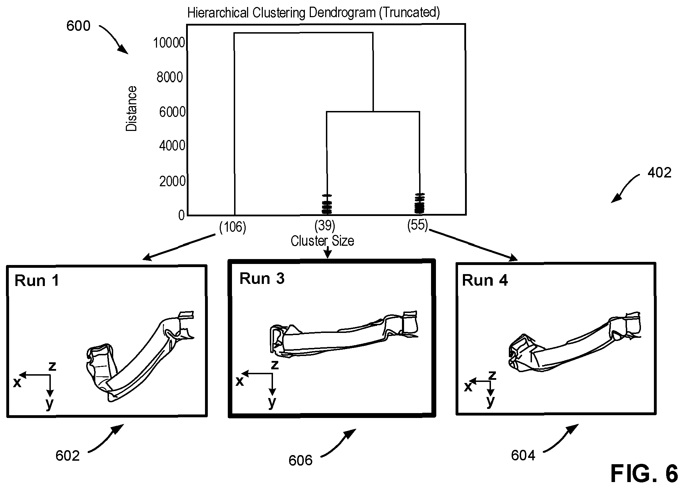

A clustering algorithm 510 is used to cluster the second set of features into a plurality of clusters. In some examples, user interaction can be used to decide on the number of groups that the set can be divided into and label them accordingly. For example, the user input can include, for at least some of the clusters, an indication of a respective quality metric assigned to that cluster by the user e.g., good/medium/bad. For example, the number of groups can be automatically determined according to a quality metric (e.g., elbow method or silhouette score) or set by the user as some positive value. The generated clusters are arbitrarily labelled as 1, 2, 3,...,N. A user can review the clusters and relabel them into something meaningful. Once the number of clusters has been determined the clustering algorithm can automatically generate the number of clusters. In an example where the number of clusters is determined by the user, the user can be presented with the result of the clustering algorithm (an example is shown in FIG. 6). Depending on the presented result the user can chose to increase or decrease the number of clusters. For example, in the case of displacement modes the user can choose to have one group per distinguishable node.

Examples of appropriate clustering algorithms include k-means clustering, hierarchical clustering, Density-Based Spatial Clustering of Applications with Noise (DBSCAN) etc.

A classifier model 512 based on the clusters can be trained to predict a quality metric of the structural design of the article as a function of an input set of features of the system, the quality metric corresponding to a subjective evaluation of the structural design. The classifier model can be trained using at least one of a logistic regression analysis, a random forest analysis, a neural network or other classifier algorithm.

Once the above process has been completed a second set of design variables 514 for the structural design of the article can be passed to the predictive model 508 for determining, a third set of features of the structural design of the article based on the second set of design variables and the predictive model, and determining, by the one or processors, the quality metric 516 of the structural design of the article based on the third set of features and the classifier model.

FIG. 6 is an example diagram of the output of a clustering algorithm, as described with reference to FIG. 5. In an example, the article is a structural component of a vehicle and the output of the clustering algorithm 600 clusters the reduced set of features into bad 602, medium 604, and good 606 clusters.

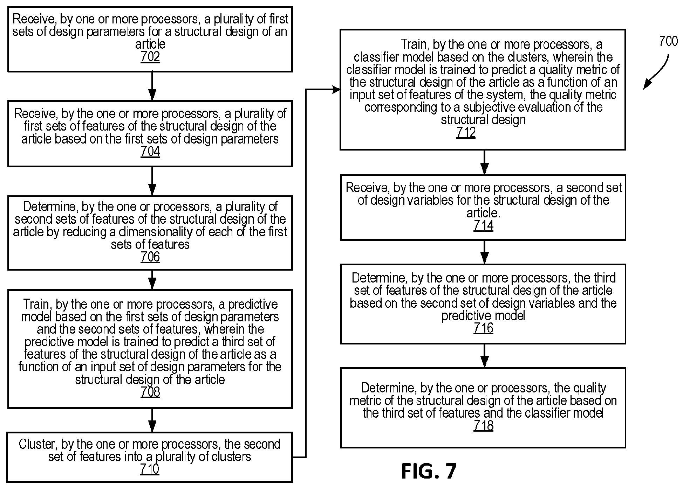

FIG. 7 is a flow chart diagram of an example process 700 for expert emulation. The process can include receiving by one or more processors, a plurality of first sets of design parameters for a structural design of an article (block 702).

The one or more processors also receive a plurality of first sets of features of the structural design of the article based on the first sets of design parameters (block 704). The first set of features can include an indication of displacement of a structural component e.g., a structural component of a vehicle. The first of features can be used to train a process for reducing the dimensionality of the data, e.g., an autoencoder or other dimensionality reduction algorithm e.g., PCA.

The one or more processors execute a dimensionality reduction algorithm to determine a plurality of second sets of features of the structural design of the article by reducing a dimensionality of each of the first sets of features (block 706). For example, the dimensionality reduction algorithm may reduce the number of features to a latent space with less dimensions.

The one or more processors, train a predictive model based on the first sets of design parameters and the second sets of features, where the predictive model is trained to predict a third set of features of the structural design of the article as a function of an input set of design parameters for the structural design of the article (block 708). The dimensionality reduction algorithm can also be used to map the latent space of the second set of features back to the original space. This allows the predictive model to predict the full result of the analysis in a computationally efficient manner.

The one or more processors cluster the second set of features into a plurality of clusters (block 701). The clusters can be generated using, for example, k-means clustering. The number of clusters in the plurality of clusters and/or the cluster labels can be specified by the user.

The one or more processors, train a classifier model based on the clusters, where the classifier model is trained to predict a quality metric of the structural design of the article as a function of an input set of features of the system, the quality metric corresponding to a subjective evaluation of the structural design (block 712).

The one or more processors, receive a second set of design variables for the structural design of the article (block 714) and determine the third set of features of the structural design of the article based on the second set of design variables and the predictive model (block 716). For example, the second set of design variables (design parameters) are clustered into one of the specified clusters.

The one or more processors determine a quality metric of the structural design of the article based on the third set of features and the classifier model (block 718). The quality metric can be, for example, a vector of probabilities corresponding to each class. The probability of the target class can be used as a constraint to the optimization problem.

Although example implementations are described with respect to the design of a structural component of a vehicle, in practice, the techniques described herein can be used to improve the design of any article. For example, the techniques described herein can be used to improve the design of a structural component of a building, a consumer product, or any other article.

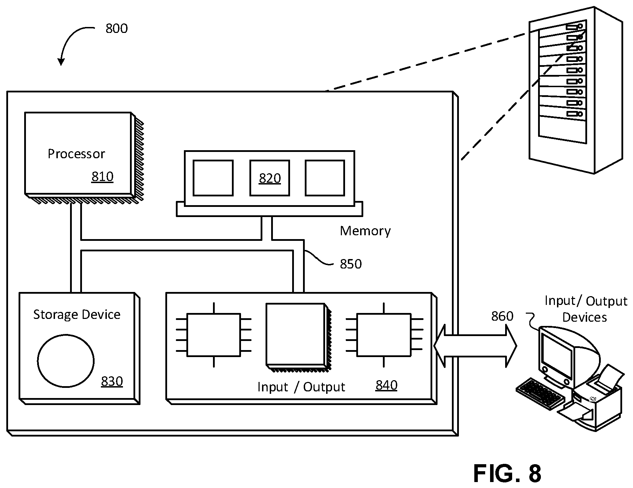

FIG. 8 shows an example computer system 800. Computer system 800 may be used to implement, at least in part, expert emulation platform 150. Process 700 can be performed at least in part, using the computer system 800. Computer system 800 includes a processor 810, a memory 820, a storage device 830 and an input/output device 840. Each of the components 810, 820, 830 and 840 can be interconnected, for example, by a system bus 850. The processor 810 is capable of processing instructions for execution within the system 800. In some implementations, the processor 810 is a single-threaded processor, a multi-threaded processor, or another type of processor. The processor 810 is capable of processing instructions stored in the memory 820 or on the storage device 830. The memory 820 and the storage device 830 can store information within the system 800.

The input/output device 840 provides input/output operations for the system 800. In some implementations, the input/output device 840 can include one or more of a network interface device, e.g., an Ethernet card, a serial communication device, e.g., an RS-232 port, and/or a wireless interface device, e.g., an 802.11 card, a 3G wireless modem, a 4G wireless modem, a 5G wireless modem, etc. In some implementations, the input/output device can include driver devices configured to receive input data and send output data to other input/output devices, e.g., keyboard, printer and display devices 860. In some implementations, mobile computing devices, mobile communication devices, and other devices can be used.

While this specification contains many details, these should not be construed as limitations on the scope of what may be claimed, but rather as descriptions of features specific to particular examples. Certain features that are described in this specification in the context of separate implementations can also be combined. Conversely, various features that are described in the context of a single implementation can also be implemented in multiple embodiments separately or in any suitable subcombination.

A number of embodiments have been described. Nevertheless, various modifications may be made without departing from the scope of the invention. Accordingly, other embodiments are within the scope of the claims.

## Claims

1. A method (700) comprising:
receiving (702), by one or more processors, a plurality of first sets of design parameters for a structural design of an article, wherein the article is a structural component of a vehicle, and wherein at least one of the first sets of design parameters comprises an indication of a thickness or a location of a portion of the structural component;
determining (704), by the one or more processors, a plurality of first sets of features of the structural design of the article based on the first sets of design parameters, wherein at least one of the first sets of features comprises an indication of one or more deformations of the structural component in response to an applied force;
determining (706), by the one or more processors, a plurality of second sets of features of the structural design of the article by reducing a dimensionality of each of the first sets of features;
training (708), by the one or more processors, using a regression algorithm, a predictive model based on the first sets of design parameters and the second sets of features, wherein the predictive model is trained to predict a third set of features of the structural design of the article as a function of an input set of design parameters for the structural design of the article;
clustering (710), by the one or more processors, the second set of features into a plurality of clusters;
training (712), by the one or more processors, a classifier model based on the clusters, wherein the classifier model is trained to predict a quality metric of the structural design of the article as a function of an input set of features, the quality metric corresponding to a subjective evaluation of the structural design based on whether a level of deformation is acceptable;
receiving (714), by the one or more processors, a second set of design parameters for the structural design of the article;
determining (716), by the one or more processors, the third set of features of the structural design of the article based on the second set of design parameters and the predictive model;
determining (718), by the one or more processors, the quality metric of the structural design of the article based on the third set of features and the classifier model;
using the determined quality metric to improve the structural design of the structural component based on an optimization method, wherein the designed structural component is for use in a vehicle.

2. The method of claim 1, wherein at least one of the second sets of features comprises an indication of one or more deformations of the structural component in response to an applied force.

3. The method of claim 1, wherein the classifier model is trained based on input by a user.

4. The method of claim 1, wherein the input comprises, for at least some of the clusters, an indication of a respective quality metric assigned to that cluster by a user.

5. The method of claim 1, further comprising:
determining, by the one or more processors, a fourth set of features of the structural design of the article by increasing a dimensionality of the third set of features, optionally wherein the dimensionality of the third set of features is increased by at least one of principal component analysis or an auto-encoder.

6. The method of claim 1, wherein the dimensionality of each of the first sets of features is reduced by at least one of principal component analysis or an auto-encoder.

7. The method of claim 1, wherein the predictive model is trained using at least one of a least square regression analysis, Gaussian process regression analysis, or a neural network.

8. The method of claim 1, wherein the classifier model is trained using at least one of a logistic regression analysis, a random forest analysis, or a neural network.

9. A non-transitory computer-readable medium including one or more sequences of instructions which, when executed by one or more processors, causes the one or more processors to perform the method of any one of the preceding claims.

10. A system comprising:
one or more processors; and
one or more non-transitory computer-readable media including one or more sequences of instructions which, when executed by the one or more processors, cause the one or more processors to perform the method of any one of claims 1 to 8.

11. The method of any one of claims 1 to 8, further comprising using the designed structural component in the vehicle.

## Patentansprüche

1. Verfahren (700), umfassend:
Empfangen (702) einer Mehrzahl von ersten Sätzen von Entwurfsparametern für einen Strukturentwurf eines Gegenstands durch einen oder mehrere Prozessoren, wobei der Gegenstand eine Strukturkomponente eines Fahrzeugs ist und wobei mindestens einer der ersten Sätze von Entwurfsparametern eine Angabe einer Dicke oder einer Position eines Teils der Strukturkomponente umfasst;
Bestimmen (704) einer Mehrzahl von ersten Sätzen von Merkmalen des Strukturentwurfs des Gegenstands durch den einen oder die mehreren Prozessoren basierend auf den ersten Sätzen von Entwurfsparametern, wobei mindestens einer der ersten Sätze von Merkmalen eine Angabe einer oder mehrerer Verformungen der Strukturkomponente in Reaktion auf eine aufgebrachte Kraft umfasst;
Bestimmen (706) einer Mehrzahl von zweiten Sätzen von Merkmalen des Strukturentwurfs des Gegenstands durch den einen oder die mehreren Prozessoren durch Reduzieren einer Dimensionalität jedes der ersten Sätze von Merkmalen;
Trainieren (708) eines Vorhersagemodells durch den einen oder die mehreren Prozessoren basierend auf den ersten Sätzen von Entwurfsparametern und den zweiten Sätzen von Merkmalen unter Verwendung eines Regressionsalgorithmus, wobei das Vorhersagemodell trainiert wird, um einen dritten Satz von Merkmalen des Strukturentwurfs des Gegenstands als eine Funktion eines Eingabesatzes von Entwurfsparametern für den Strukturentwurf des Gegenstands vorherzusagen;
Clustern (710) des zweiten Satzes von Merkmalen durch den einen oder die mehreren Prozessoren zu einer Mehrzahl von Clustern;
Trainieren (712) eines Klassifizierermodells durch den einen oder die mehreren Prozessoren basierend auf den Clustern, wobei das Klassifizierermodell trainiert wird, um eine Qualitätsmetrik des Strukturentwurfs des Gegenstands als eine Funktion eines Eingabesatzes von Merkmalen vorherzusagen, wobei die Qualitätsmetrik einer subjektiven Bewertung des Strukturentwurfs entspricht, die darauf basiert, ob ein Verformungsgrad akzeptabel ist;
Empfangen (714) eines zweiten Satzes von Entwurfsparametern für den Strukturentwurf des Gegenstands durch den einen oder die mehreren Prozessoren;
Bestimmen (716) des dritten Satzes von Merkmalen des Strukturentwurfs des Gegenstands durch den einen oder die mehreren Prozessoren basierend auf dem zweiten Satz von Entwurfsparametern und dem Vorhersagemodell; Bestimmen (718) der Qualitätsmetrik des Strukturentwurfs des Gegenstands durch den einen oder die mehreren Prozessoren basierend auf dem dritten Satz von Merkmalen und dem Klassifizierermodell;
Verwenden der bestimmten Qualitätsmetrik, um den Strukturentwurf der Strukturkomponente basierend auf einem Optimierungsverfahren zu verbessern, wobei die entworfene Strukturkomponente zur Verwendung in einem Fahrzeug ist.

2. Verfahren nach Anspruch 1, wobei mindestens einer der zweiten Sätze von Merkmalen eine Angabe einer oder mehrerer Verformungen der Strukturkomponente in Reaktion auf eine aufgebrachte Kraft umfasst.

3. Verfahren nach Anspruch 1, wobei das Klassifizierermodell basierend auf einer Eingabe durch einen Benutzer trainiert wird.

4. Verfahren nach Anspruch 1, wobei die Eingabe für mindestens einige der Cluster eine Angabe einer jeweiligen Qualitätsmetrik umfasst, die diesem Cluster durch einen Benutzer zugewiesen wird.

5. Verfahren nach Anspruch 1, ferner umfassend:
Bestimmen eines vierten Satzes von Merkmalen des Strukturentwurfs des Gegenstands durch den einen oder die mehreren Prozessoren durch Erhöhen einer Dimensionalität des dritten Satzes von Merkmalen, wobei optional die Dimensionalität des dritten Satzes von Merkmalen durch mindestens eines von einer Hauptkomponentenanalyse oder einem Autoencoder erhöht wird.

6. Verfahren nach Anspruch 1, wobei die Dimensionalität jedes der ersten Sätze von Merkmalen durch mindestens eines von einer Hauptkomponentenanalyse oder einem Autoencoder reduziert wird.

7. Verfahren nach Anspruch 1, wobei das Vorhersagemodell unter Verwendung mindestens eines von einer Regressionsanalyse nach der Methode der kleinsten Quadrate, einer Gauß-Prozess-Regressionsanalyse oder einem neuronalen Netzwerk trainiert wird.

8. Verfahren nach Anspruch 1, wobei das Klassifizierermodell unter Verwendung mindestens eines von einer logistischen Regressionsanalyse, einer Random-Forest-Analyse oder einem neuronalen Netzwerk trainiert wird.

9. Nichtflüchtiges computerlesbares Medium, aufweisend eine oder mehrere Sequenzen von Anweisungen, die bei Ausführung durch einen oder mehrere Prozessoren den einen oder die mehreren Prozessoren zum Durchführen des Verfahrens nach der vorhergehenden Ansprüche veranlassen.

10. System, umfassend:
einen oder mehrere Prozessoren; und
ein oder mehrere nichtflüchtige computerlesbare Medien, die eine oder mehrere Sequenzen von Anweisungen aufweisen, die bei Ausführung durch den einen oder die mehreren Prozessoren den einen oder die mehreren Prozessoren zum Durchführen des Verfahrens nach Anspruch 1 bis 8 veranlassen.

11. Verfahren nach einem der Ansprüche 1 bis 8, ferner umfassend Verwenden der entworfenen Strukturkomponente in dem Fahrzeug.

## Revendications

1. Procédé (700) comprenant :
la réception (702), par un ou plusieurs processeurs, d'une pluralité de premiers ensembles de paramètres de conception pour une conception structurelle d'un article, l'article étant un composant structurel d'un véhicule, et au moins un des premiers ensembles de paramètres de conception comprenant une indication d'une épaisseur ou d'un emplacement d'une partie du composant structurel ;
la détermination (704), par le ou les processeurs, d'une pluralité de premiers ensembles de caractéristiques de la conception structurelle de l'article sur la base des premiers ensembles de paramètres de conception, au moins un des premiers ensembles de caractéristiques comprenant une indication d'une ou plusieurs déformations du composant structurel en réponse à une force appliquée ;
la détermination (706), par le ou les processeurs, d'une pluralité de deuxièmes ensembles de caractéristiques du design structurel de l'article en réduisant une dimensionnalité de chacun des premiers ensembles de caractéristiques ;
l'entraînement (708), par le ou les processeurs, à l'aide d'un algorithme de régression, d'un modèle prédictif sur la base des premiers ensembles de paramètres de conception et des deuxièmes ensembles de caractéristiques, le modèle prédictif étant entraîné pour prédire un troisième ensemble de caractéristiques de la conception structurelle de l'article en fonction d'un ensemble d'entrée de paramètres de conception pour la conception structurelle de l'article ;
le regroupement (710), par le ou les processeurs, du deuxième ensemble de caractéristiques en une pluralité de groupes ;
l'entraînement (712), par le ou les processeurs, d'un modèle classificateur sur la base des groupes, le modèle classificateur étant entraîné pour prédire une métrique de qualité de la conception structurelle de l'article en fonction d'un ensemble d'entrée de caractéristiques, la métrique de qualité correspondant à une évaluation subjective de la conception structurelle basée sur le fait qu'un niveau de déformation soit acceptable ou non ;
la réception (714), par le ou les processeurs, d'un deuxième ensemble de paramètres de conception pour la conception structurelle de l'article ;
la détermination (716), par le ou les processeurs, du troisième ensemble de caractéristiques du design structurel de l'article sur la base du deuxième ensemble de paramètres de conception et du modèle prédictif ;
la détermination (718), par le ou les processeurs, de la métrique de qualité de la conception structurelle de l'article sur la base du troisième ensemble de caractéristiques et du modèle classificateur ;
l'utilisation de la métrique de qualité déterminée pour améliorer la conception structurelle du composant structurel sur la base d'une méthode d'optimisation, le composant structurel conçu étant destiné à être utilisé dans un véhicule.

2. Procédé selon la revendication 1, au moins un des deuxièmes ensembles de caractéristiques comprenant une indication d'une ou plusieurs déformations du composant structurel en réponse à une force appliquée.

3. Procédé selon la revendication 1, le modèle classificateur étant entraîné sur la base d'une entrée par un utilisateur.

4. Procédé selon la revendication 1, l'entrée comprenant, pour au moins certains des groupes, une indication d'une métrique de qualité respective attribuée au groupe en question par un utilisateur.

5. Procédé selon la revendication 1, comprenant en outre :
la détermination, par le ou les processeurs, d'un quatrième ensemble de caractéristiques de la conception structurelle de l'article par augmentation de la dimensionnalité du troisième ensemble de caractéristiques, la dimensionnalité du troisième ensemble de caractéristiques étant éventuellement augmentée par une analyse en composantes principales et/ou un auto-encodeur.

6. Procédé selon la revendication 1, la dimensionnalité de chacun des premiers ensembles de caractéristiques étant réduite par une analyse en composantes principales et/ou un auto-encodeur.

7. Procédé selon la revendication 1, le modèle prédictif étant entraîné à l'aide d'au moins un moyen parmi une analyse de régression aux moindres carrés, une analyse de régression par processus gaussien ou un réseau neuronal.

8. Procédé selon la revendication 1, le modèle classificateur étant entraîné à l'aide d'au moins un moyen parmi une analyse de régression logistique, une analyse de forêt aléatoire ou un réseau neuronal.

9. Support non transitoire lisible par ordinateur comprenant une ou plusieurs suites d'instructions qui, lorsqu'elles sont exécutées par un ou plusieurs processeurs, amènent le ou les processeurs à réaliser le procédé selon l'une quelconque des revendications précédentes.

10. Système comportant :
un ou plusieurs processeurs ; et
un ou plusieurs supports non transitoires lisibles par ordinateur comprenant une ou plusieurs suites d'instructions qui, lorsqu'elles sont exécutées par le ou les processeurs, amènent le ou les processeurs à réaliser le procédé selon l'une quelconque des revendications 1 à 8.

11. Procédé selon l'une quelconque des revendications 1 à 8, comprenant en outre l'utilisation du composant structurel conçu dans le véhicule.
